(19) Europäisches Patentamt
European Patent Office
Office européen des brevets

(11) **EP 1 928 007 A1**

(12) **EUROPEAN PATENT APPLICATION**

(43) Date of publication:
**04.06.2008 Bulletin 2008/23**

(51) Int Cl.:
***H01H 9/56*** (2006.01)    ***H02H 3/02*** (2006.01)
***G01R 19/175*** (2006.01)    ***G01R 19/25*** (2006.01)

(21) Application number: **06125262.3**

(22) Date of filing: **01.12.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK RS**<br><br>(71) Applicant: **ABB Technology Ltd**<br>**8050 Zürich (CH)** | (72) Inventor: **Thomas, Richard**<br>**771 41, Ludvika (SE)**<br><br>(74) Representative: **Reyier, Ann-Mari et al**<br>**Bjerkéns Patentbyra KB**<br>**Box 128**<br>**721 05 Västeras (SE)**<br><br><u>Remarks:</u><br>Amended claims in accordance with Rule 137 (2) EPC. |

(54) **A method and apparatus for predicting the future behavior of current paths**

(57)    The present invention relates to a method and an apparatus for predicting the future behavior of currents in current paths (1a-c) in a multi-phase alternating current electrical power system. The apparatus comprises: a first member (3) adapted to continuously sample the voltage for at least one of said current paths, a second member (2) adapted to continuously sample the current for the current paths, a computation unit (5) adapted estimate phase-to-ground parameters and phase-to-phase parameters for the voltage of the current paths based on the values of the voltage, a predictor arrangement (6) adapted to predict a first set of current values for the current paths based on the estimated phase-to-ground parameters, and to predict a second set of current values for the current paths based on the estimated phase-to-phase parameters, a comparator (8) adapted to compare the first and second set of predicted current values with sampled current values from the same point in time, and an evaluation module (10) adapted to based thereon determine whether the first or second set of predicted current values is a valid prediction of the current in the path.

Fig. 2

EP 1 928 007 A1

**Description**

FIELD OF THE INVENTION

The present invention relates to a method and an apparatus for predicting future behavior of current(s) in current paths forming phases in a multi-phase alternating current (AC) electrical power system, which currents may exhibit transient asymmetric behavior. The invention is directed towards multi-phase, e.g., 2-phase, 3-phase, alternating current (a.c.) electric power systems. The invention is particularly useful for predicting future behavior of fault current(s) in multi-phase AC-power systems, having high-voltage AC circuit breakers using either arc-based or power electronic based interrupters.

PRIOR ART

Alternating-current circuit breakers rely on interrupting currents at natural current zero crossings. After the circuit breaker receives an "open" or "trip" command, its contacts will start to move to the open position. As the contacts separate, the current will be conducted by an arc formed between the contacts. The current will be successfully interrupted at a current zero, provided sufficient contact gap and arc cooling has occurred, e.g. by dielectric flow into the arc region. The earliest current zero for successful interruption will occur after a minimum arcing time. The minimum arcing time required may vary according to the magnitude and nature of the current.

A fault current is a current transient caused, for example, by a short circuit in the current path. When such a fault current occurs a current interruption device has to open the current path, i.e. to break the current, as soon as possible to prevent damaging different types of equipment connected to the current path.

Fault currents must be interrupted very quickly in order to minimize damage to power system equipment and avoid risk of transient system instability leading to wide scale power system collapse (e.g. blackout). Protection relay systems are designed to detect faults quickly and then issue trip commands to circuit breakers to interrupt the fault currents. Faults occur randomly without advance notice, and the issuing of the trip commands is not synchronized to the fault current zero times. As such a circuit breaker may see a wide range of arcing times and must be designed and type tested accordingly. In general modern breakers are designed to cater for arcing times ranging up to 0.5-1.5 cycles of power frequency and thereby aim at having at least two current zero crossings between contact separation and the end of contact opening travel.

There is a limit for acceptable arcing wear in an arc based interrupting device, beyond which the interruption performance of the interrupter according to its rated performance values can no longer be assured. At this limit the worn interrupter parts must be replaced. The larger the current being interrupted and longer the arcing time, the more wear occurs on the interrupter arcing contacts and nozzle due to larger net radiated arc energy. Thus, if the arcing time can be restricted, the interrupter wear can also be reduced and the circuit breaker can be used for longer periods between intrusive interrupter maintenance. Having an arcing time longer than the minimum arcing time adds to the electrical wear of the interrupters without adding any contribution to the eventual interruption of the current. Accordingly, there is a desire to be able to predict the behaviour of fault currents in power systems with a high degree of accuracy. More specifically, it is a desired to predict the current zero crossings of the fault current in the individual case so as to be able to achieve interruption with an optimal arcing time.

In addition to arc based interruption devices, there exist other devices for current interruption, for example diode or thyristor based devices that interrupt without arc formation inside the device. Such devices will still interrupt at current zero crossings. However, such devices can be limited in the amount of time they can conduct current, and as such it can be desirable to implement such devices with a control scheme that synchronizes when they are active in the circuit, commonly referred to as commutation, i.e. switching current flow from one current path to another current path. Such a control scheme would therefore need to predict current behaviour, in particular future current zero crossing times.

In addition to arc-based interrupter breakers, synchronized interruption control with respect to target current zero times is also of potential benefit to interrupters using power electronic devices. Typically such interrupters are made up of a combination of diodes and series contacts whereby the diodes provide current conduction in place of an arc and the series contacts provide dielectric withstand against transient recovery and open interrupter voltages. Such devices require some form of commutation control to switch the diode components in circuit during the current loop prior to the interruption current zero and to also open the series contacts at or just prior to the interruption current zero in order to provide the necessary dielectric recovery withstand performance.

The international patent application WO2006/043871 describes an apparatus and method for predicting fault current zero crossings as a means to control the arcing time of alternating current interruption devices. The method teaches that sampled values of the current are saved in a moving sampling window, future values of the current are continuously predicted, and sampled values of the current from the same point in time are compared with the predicted values of the current, and on basis thereof it is continuously determined whether or not a fault current has occurred in the current path. When a fault current has been detected, the sampling window is adjusted to discard current values prior to the fault current. Thereafter, future values of the fault current are predicted based on the current values in the adjusted sampling window. In a single-phase power system, the only type of fault current that may occur is phase-to-ground faults. A phase-to-ground fault occurs when a phase is connected to ground or earth. A phase-to-ground fault is also denoted a grounded fault or an earth fault. This method achieves an accurate prediction of a fault current in a single-phase alternating current electric power system.

However, in a multi-phase power system there exists other types of faults, such as 2-phase ungrounded faults (short circuit between two phases), 3-phase ungrounded faults (short circuit between three phases), 2-phase grounded faults, which occur when two phases are connected to ground, and 3-phase grounded faults, which occurs when three phases are connected to ground. The type of fault can be divided into two classes; grounded faults, also denoted phase-to-ground or phase-to-earth type of faults, and ungrounded faults, also denoted phase-to-phase type of faults. A phase-to-phase fault occurs when there is a short circuit between two or more phases without connection to ground, such as 2-phase ungrounded faults and 3-phase ungrounded faults. A phase-to-ground fault occurs when one or more of the phases are connection to ground, such as 1,2 or 3-phase grounded faults.

Major problems to be solved for multi phase fault interruption include:

(1) Randomness of fault occurrence. Faults occur with no prior warning.

(2) Faults must be interrupted quickly. Time for calculating synchronized control is very limited (typically between 0.25 - 1 cycle after fault start).

(3) Faults are typically characterized by an initial stage of exponentially decaying transient asymmetry, meaning that current zeroes are no longer periodic as during normal load operation. The level and duration of asymmetry is determined by both the source-to-fault power system inductance-to-resistance ratio (L/R) and the angle on the driving source voltage at which the fault starts.

(4) There are a range of fault combinations possible in a multi-phase system e.g. for a three phase system; single, double and three phase to ground faults in addition to phase-to-phase ungrounded faults.

(5) In non-effectively grounded power systems, or in cases of three phase faults without ground connection, the currents in the last two phases to clear will shift into phase opposition after the first phase interrupts.

Most of the above problems cannot be solved by prior assumption and must be solved in real time between the time the fault starts and when the associated protection relay system has determined that a fault has occurred and sends trip signal(s) to the associated circuit-breaker(s) to interrupt.

References to prior art methods for fault type classification can be found in reference to relay protection schemes, but more specifically with respect to controlled fault interruption, one can refer to Anton Poeltl and Klaus Fröhlich's IEEE paper entitled "Two new methods for very fast fault type detection by means of parameter fitting and artificial neural networks", IEEE Transactions on Power Delivery, Vol. 14, No.4, 1999, describing a method for detecting fault types in a multi-phase system by means of an Artificial Neural Network (ANN) method. However, the proposed method does not predict future values of the current.

OBJECTS AND SUMMARY OF THE INVENTION

The object of the present invention is to provide a possibility to predict the future behavior of the currents in current paths forming phases in a multi-phase alternating current electrical power system.

According to one aspect of the invention this object is achieved by a method as defined in claim 1.

Such a method comprises continuously saving sampled values of the voltage for at least one of the current paths, and continuously saving sampled values of the current for each of the current paths. The method further comprises for each of the current paths: estimating one or more phase-to-ground parameters for the voltage of the current path based on the stored values of the voltage, predicting a first set of current values based on a mathematical model of the current, the estimated phase-to-ground parameters, and the sampled values of the current, performing a first comparison between said first set of predicted current values and sampled values of the current from the same point in time, estimating one or more phase-to-phase parameters for the voltage of the current path based on the stored values of the voltage, predicting a second set of current values based on said mathematical model of the current, the estimated phase-to-phase parameters, and the stored sampled values of the current, performing a second comparison between said second set of predicted current values and sampled values of the current from the same point in time, determining whether the first or second set of predicted current values is a valid prediction of the current in the path based on the results of said first and second comparison, and if any of the first or second set of predicted current value is found to be valid, predicting future values of the current of the path based on the model and the parameters used for predicting the valid set of current values.

The proposed invention makes it possible to continuously predict the future behavior of currents in all phases of a multi-phase alternating current system for phase-to-ground faults as well as for phase-to-phase faults.

If a fault has occurred, it is not possible to immediately know the type of the fault. For instance, it is not possible to know if it is a phase-to-ground fault or a phase-to-phase fault. According to the invention, future current values are predicted based on a current model including one or more characteristic parameters, which have different values in dependence on whether they are evaluated in terms of a phase-to-ground or a phase-to-phase frame of reference, and the characteristic parameters of the current model are evaluated for a phase-to-ground as well as a phase-to-phase frame of reference. In the following, characteristic parameters of the current model evaluated for a phase-to-ground frame are denoted phase-to-ground parameters, and characteristic parameters of the current model evaluated for a phase-to-phase frame are denoted phase-to-phase parameters.

A first set of current values is predicted based the estimated phase-to-ground parameter values and a second set of current values is predicted based the estimated phase-to-phase parameter values. So in effect, two estimations are generated for the current in each current path. One of the current estimation is based on phase-to-ground parameter input values to the current model and the other current estimation is based on phase-to-phase parameter input values to the current model. The estimated currents are compared with measured values from the same point in time in order to determine if any of the estimated currents is a valid estimation of the current behavior. The estimated current is valid, if the comparison presents a small deviation between the estimated and the measured currents. The characteristic parameters that give the closest approximation to the measured current are used for the ongoing prediction of the current behavior.

In some rare cases, none of the estimated currents presents a valid estimate of the current, i.e. the comparison gives a too large deviation between the estimated and the measured currents, e.g. where there is noise on the measurement signals of the current and/or voltage that cause errors in the estimation of the "true" characteristic parameter values of the current according to the chosen model of the current. Another example of measurement signal distortion that might not be modeled is saturation of current transformer cores, causing distortion of the current signal used for evaluating the characteristic parameter values required by the chosen model of the current. In those cases, it is not possible to determine a valid model of the current and accordingly it is not possible to predict the current. If this is the case, another strategy has to be used. For example, a "bypass" strategy can be implemented.

The method is based on predicting future current behavior using a generic current model including a transient exponentially decaying direct current (d.c.) component that may arise after a change in power system conditions, e.g. inception of a fault or switching of another part of the power system. Only the values of some of the characteristic parameters of the current model need to be adjusted to manage certain fault types. In particular two main fault groupings need only be considered, faults involving and faults not involving a ground connection. Hence the invention makes calculation of the parameter values for the model of the current for both of these cases and evaluates which of these best matches the actual sampled current values.

Preferably, the characteristic parameters of the current model include the phase shift of the voltage of the current path with respect to a reference phase. Thus, the phase shift of the phase-to-ground voltage for the current path is estimated with respect to a reference phase and the phase shift of the phase-to-phase voltage between the current paths is estimated with respect to the same reference phase. The inclusion of the phase shift in the current model provides a fairly "generic" model of the current. Also, the value of the phase shift is not the same for different 2-phase ungrounded faults where the same phase might occur in either case, i.e. the phase-to-phase phase shift value for say "B" phase, is not the same for an "A-B" fault as it is for a "B-C" fault.

Preferably, the characteristic parameters of the current model also include the phase angle of the voltage of the current path. Thus, the phase angle of the phase-to-ground voltage for the current path and the phase angle of the phase-to-phase voltage between the current paths are estimated.

A change in the current will, for example, occur with switching anywhere on the network and normally result in some form of switching transient. The changes in current may depend on faults that manifest themselves with significant transient asymmetry. However even the switching on or off of a "normal" load could result in similar (though perhaps not as dramatic) transients. A fault is simply an extreme and unpredictable case of this. One can think of the fault as being "switched onto" the network, though it is due to some form of accident or breakdown of equipment or natural event e.g. tree falling on line or lightning strike etc.

According to an embodiment of the invention, the deviation between the first and second comparison is calculated and based thereon, it is determined whether or not a change in current has occurred in the current path. The deviation between the predicted currents and the measures currents will be the same for the phase-to-ground and the phase-to-phase estimate, until a change in the current occurs. The occurrence of a change in the current will mean that the measured and estimated currents will start to diverge for at least one of the phase-to-ground and the phase-to-phase estimate. Thus, as long as the deviation between the first and second comparison is small, the current is at a steady state. A change in current will cause an increasing deviation between the first and second deviation. Therefore, it is advantageous to detect changes in the current based on the deviations between the fist and second comparisons.

At start up, the phase-to-phase parameter values are set to same as the phase-to-ground parameter values, so that the estimated currents will be the same. Hence, values of the first and second comparisons will be the same until a fault occurs.

According to an embodiment of the invention, upon detecting that a change in the current has occurred in the current path, the estimated phase shift of the phase-to-phase voltage and the estimated phase shift of the phase-to-ground voltage are adjusted. Preferably, also the phase angle is adjusted upon detecting that a change in current state, e.g. a fault or a load-switching event, has occurred, based on the fault start instant.

According to an embodiment of the invention, said sampled values of the current for a current path are stored in a moving window, and the method further comprises: upon detecting that a change has occurred in the current in the current path, the moving window for the current is adjusted to discard current values prior to the change in current, and predicting future values of the current based on the present values in the adjusted moving window. When a fault current has been detected the sampling window is adjusted to discard current values prior to the fault current. Thereafter, future values of the fault current are predicted based on the current values in the adjusted sampling window. Thanks to the fact that current values prior to the fault current are rejected upon detecting that a fault current has occurred, the prediction of the fault current at its beginning is improved.

According to an embodiment of the invention, the estimated phase-to-ground parameters for the voltage are used for estimating further characteristic parameters for the current.

According to an embodiment of the invention, which of the phases are involved in a fault is determined based on said first comparisons, also denoted F0, for all current paths. One has to choose at least one version of the current model to act as a "fault detector" and as the majority of faults on a power network do actually involve connection to ground, it is convenient to use the tracking of the F0 results for the phase-to-ground model of the current for this purpose. The determination of which phases are affected by a fault comes automatically from the F0 tracking performed on each of the currents in each respective phase or current path.

According to an embodiment of the invention, the method comprises determining whether or not there is a three-phase fault, and in case there is a three-phase fault: interrupting the current of one of the current paths, estimating possible interruption current zeros for the remaining current paths based on said model and both the phase-to-ground and the phase-to-phase parameters, and selecting the earliest current zero in each path and interrupt the currents at the selected current zero. The method according to the invention can predict current for all fault cases except for three-phase faults as it is not possible to differentiate between a three phase grounded and a three phase ungrounded fault before the first phase is interrupted. It is not acceptable to wait for the first phase to interrupt to adjust the control of the last phases to interrupt, since the fault must be interrupted as quickly as possible. This embodiment solves this problem by implementing a compromise targeting solution for the last phases to be interrupted. The invention identifies the first phase to interrupt, and then for the remaining phases estimates their possible interruption current zeroes for both the grounded (phase-to-ground) and the phase-to-phase cases. The invention then selects the earliest current zero in each phase as the target for that phase. At least one of these current zeroes will be correct for a given phase, while the other phase may experience a slightly longer than expected arcing time.

According to an embodiment of the invention, the method comprises determining the type of fault based on said first and second comparisons. Once a fault occurs, how the characteristic parameters of the model will change depends on the type of fault. This embodiment makes it possible to discriminate phase-to-phase faults from phase-to-ground faults.

According to an embodiment of the invention, the method comprises determining whether the fault is a 2-phase to ground fault or a phase-to-phase without ground fault based on said first and second comparisons. It is necessary to use the correct parameter values in the current model in order to correctly model either a phase-to-ground or phase-to-phase current case. The phase-to-ground values and a simpler phase-to-ground current model will not work for phase-to-phase faults.

It is easy to realize that the method according to the invention, as defined in the appended set of method claims, is suitable for execution by a computer program having instructions corresponding to the steps in the inventive method when run on a processor unit.

According to a further aspect of the invention, the object is achieved by a computer program product directly loadable into the internal memory of a computer or a processor, comprising software code portions for performing the steps of the method according to the appended set of method claims, when the program is run on a computer. The computer program is provided either on a computer-readable medium or through a network

According to another aspect of the invention, the object is achieved by a computer readable medium having a program recorded thereon, when the program is to make a computer perform the steps of the method according to the appended set of method claims, and the program is run on the computer.

According to another aspect of the invention this object is achieved by an apparatus as defined in claim 16.

Further developments of the device are characterized by the features of the additional claims.

Such an apparatus is useful for predicting current zeroes of an asymmetrical fault current in a multi-phase alternating current electrical power system. The primary focus on predicting future current zero crossing times is that they can be used as targets for issuing synchronized opening commands to circuit breakers to interrupt such currents with selected arcing times.

Such an apparatus is also useful for predicting expected interruption current zero times in all phases (with or without attempted synchronization of tripping commands) for an interrupter and in the event of the interrupter failing to interrupt in any or all phases, providing a signal to a back-up protection or back-up interrupter to complete the current interruption process.

BRIEF DESCRIPTION OF THE DRAWINGS

The invention will now be explained more closely by the description of different embodiments of the invention and with reference to the appended figures.

Fig. 1                        illustrates general principals for controlled fault interruption.

Fig. 2                        shows a block diagram over a device for fault interruption of a current path including an apparatus for predicting the future behavior of currents according to an embodiment of the invention.

Fig. 3                        shows the phase shifts in a three-phase alternating current power system.

Figs. 4, 5, 6 and 7     show examples of different multiple phase fault current interruption cases that can arise in a three-phase alternating current power system.

Fig. 8                        shows predicted currents for a three phase grounded and a three phase ungrounded fault.

Fig. 9a-b                  show a method for predicting the future behavior of current(s) in current paths according to an embodiment of the invention.

Fig. 10a                   illustrates the uncertainty margin on when the primary interrupter will interrupt the currents in the paths without using current zero prediction.

Fig. 10b                   illustrates the uncertainty margin on when the primary interrupter will interrupt the currents in the paths using current zero prediction based on the method according to the invention.

DETAILED DESCRIPTION OF PREFERRED EMBODIMENTS OF THE INVENTION

In the following, by way of an example, the invention will be described in connection with an arc-based circuit breaker. The circuit breaker is connected in a current path so as to be able to rapidly open or close this and by that break and establish, respectively, the current in the current path. The primary goal of controlled fault interruption, in the following denoted CFI, is to synchronize the opening instant of arcing contacts of a circuit breaker with respect to a target current zero crossing, in the following denoted a current zero, subject to the constraint of a minimum viable arcing time prior to the target current zero. The circuit breaker is also controlled by a protection system adapted to determine whether or not the circuit breaker should be tripped and to send an order to the circuit breaker to open.

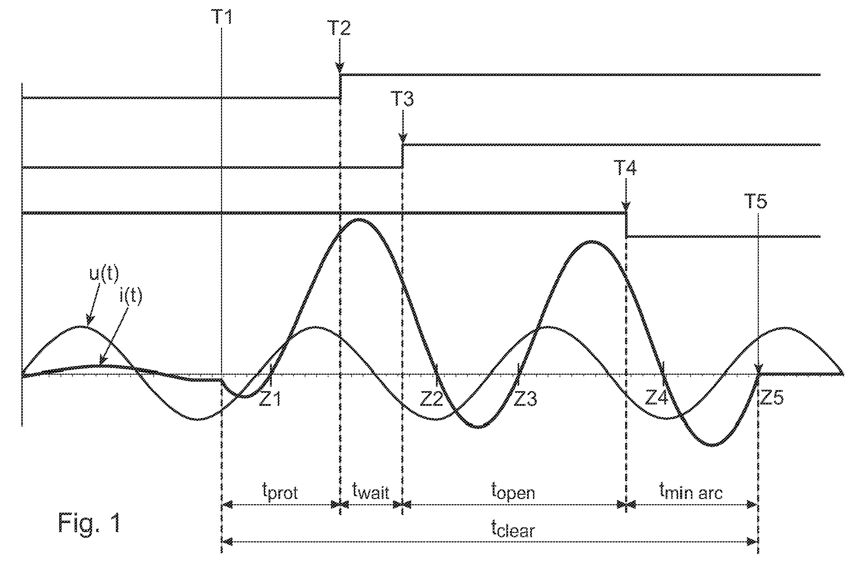

The fundamental operating principle for CFI is illustrated in figure 1. The figure illustrates the source voltage u(t) and the current i(t) before and after the point in time T1 when a fault has been initiated in a current path. As seen from the figure the fault current, i.e. the current in the current path after the fault has occurred, is asymmetric and has decreasing asymmetry. At a point in time T1 a fault current occurred. The protection system recognizes the fault at a time T2. The time period between T1 and T2 is denoted the protection response time $t_{prot}$. The protection system issues an opening signal at time T3. The time period between T2 and T3 is denoted the wait time $t_{wait}$. The time it takes from the protection system issued the opening command, until the breaker contacts starts to move away from each other is denoted the circuit breaker opening time $t_{open}$. The contact parting begins at T4. A minimum arcing time $T_{min-arc}$ corresponds to the minimum time required prior to successful interruption at a current zero crossing. The fault current in this example has five current zero crossings Z1 - Z5. At time T5 the current is interrupted at the current zero crossing Z5. The total time limit from the fault initiation to the current interrupting is the total clearing time $T_{clear}$ and lasts through about 2-3 cycles.

The ideal target for CFI is the earliest, viable current zero, occurring after fault initiation allowing for a given operating time of the protection system, the circuit breaker opening time and the minimum arcing time. Once the target has been identified and it has been determined that the breaker should be tripped, it is then a case of timing i.e. "synchronizing", the opening command to the circuit breaker in relation to its opening time such that the minimum arcing time is achieved. Thus, the trip command from the protection relay is controlled or delayed such that it results in the circuit breaker contacts separating at time that corresponds to a pre-determined arcing time between contact separation and a selected target interruption current zero.

The CFI can be implemented almost entirely as a software addition to a conventional protection system - circuit breaker installation. The CFI algorithm ideally could utilize the same measurement sources as associated protection system, even to the extent of utilizing the same signal processing system as the protection system, assuming they are of a digital numerical type. Thus, the method and apparatus according to the invention can be implemented as a software addition to a conventional protection system.

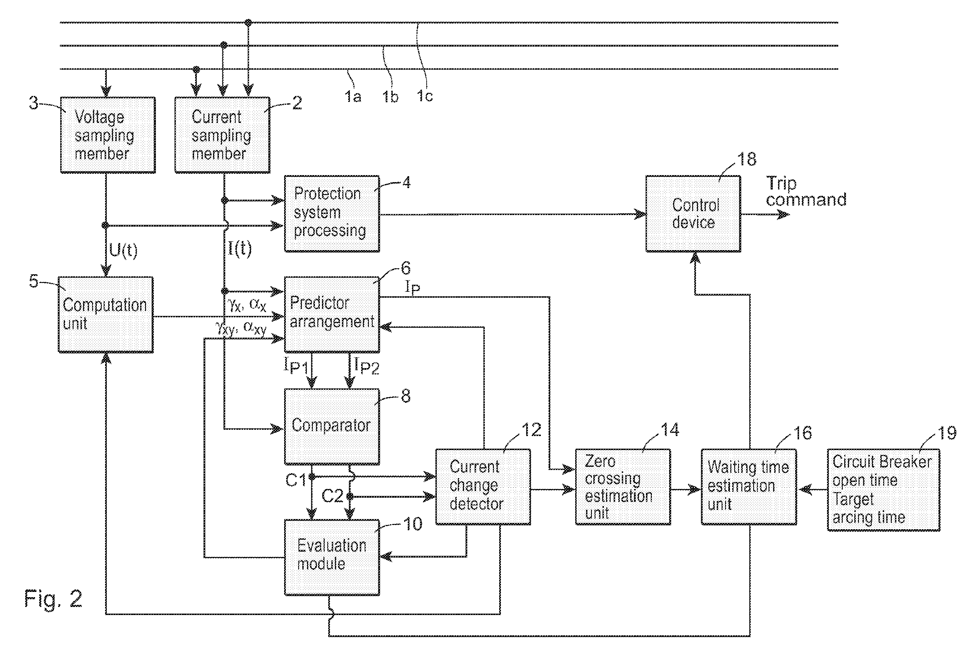

Figure 2 shows block diagram over a device for fault interruption of a current path including an apparatus for predicting the future behavior of currents according to an embodiment of the invention. Figure 2 shows the proposed apparatus in relation to the normal direct tripping protection scheme. The proposed invention would operate in parallel to the protection relay, utilizing the same sampled current and voltage measurements. If the apparatus according to the invention makes a valid estimation of the current behavior according to a model of the current embedded in the invention, a future interruption current zero is identified by extrapolation of the model of the current and a waiting time for issuing of a trip command to the breaker is calculated. If the apparatus is unable to determine a valid model of the current, a "bypass" strategy can be implemented. One bypass strategy is to force the waiting time to zero and thereby revert to direct tripping of the breaker once the protection relay trip command is sent. Another bypass strategy is to block tripping of the controlled breaker and divert the current interruption operation to a "back-up" breaker elsewhere in the power system.

In the following, the invention will be described in relation to a high voltage 3-phase system including three current paths 1a-c. However, the invention is applicable in a 2-phase or multi-phase system as well. The apparatus comprises a current sampling member 2 adapted to continuously sample the current in all three current paths 1a-c and to save sampled values of the current $I_F$ in three moving sampling window, and a voltage sampling member 3 adapted to continuously sample the voltage for at least one of the current paths and to save sampled values of the voltage $U_F$ in a moving sampling window. The fault interruption device comprises the normal protection system processing 4, which utilizes the same sampled current and voltage measurements, but is not a part of the invention.

The apparatus further comprises a computation unit 5 adapted estimate phase-to-ground parameters $\gamma_X$, $\alpha_X$ and phase-to-phase parameters $\gamma_{XY}$, $\alpha_{XY}$ for the voltage of each current path 1a-c based on the stored values of the voltage, and a predictor arrangement 6 adapted to predict a first set of current values $I_{P1}$ for each current path based on a mathematical model of the current, the estimated phase-to-ground parameters $\gamma_X$, $\alpha_X$, and the sampled values of the current $I_F$, and to predict a second set of current values $I_{P2}$ for each current path based on the mathematical model of the current, the estimated phase-to-phase parameters $\gamma_{XY}$, $\alpha_{XY}$, and the stored sampled values of the current $I_F$.

The apparatus further comprises a comparator 8 adapted to perform for each current path, a first comparison C1 between the first set of predicted current values $I_{P1}$ and sampled values of the current from the same point in time, $I_F$ and to perform a second comparison C2 between the second set of predicted current values $I_{P2}$ and sampled values $I_F$ of the current from the same point in time, and an evaluation module 10 adapted to determine for each current path, whether the first $I_{P1}$ or second $I_{P2}$ set of predicted current values is a valid prediction of the current in the path based on the results of the first and second comparison. If any of the first or second set of predicted current value is found to be valid, the predictor arrangement is informed about which model to use and continues to predict future values of the current of the path based on the parameters used for the valid set of current values. If none of the first or second set of predicted current values is found to be valid, one of the above mentioned "bypass" strategies could be used.

The apparatus further comprises a current change detector 12 adapted to calculate the deviation between the first and second comparison and based thereon determining whether or not a change in the current has occurred in the current path. A change in current is, for example, a current transient due to a switching somewhere in the system. The computation unit 5 is informed of the change in the current in any of the current path, and is adapted to upon being informed that a change in current has occurred, determine the point in time when the change in current started, and to estimate the phase angle $\alpha_X$ of the phase-to-ground voltage and the phase angle $\alpha_{xy}$ of the phase-to-phase voltage at the point in time when the change in current started based on the sampled values of the voltage. The predictor arrangement 6 is also informed of the change in current and is adapted to discard current values prior to the change, and to predict future values of the current based on the current values sampled and stored after the change in current.

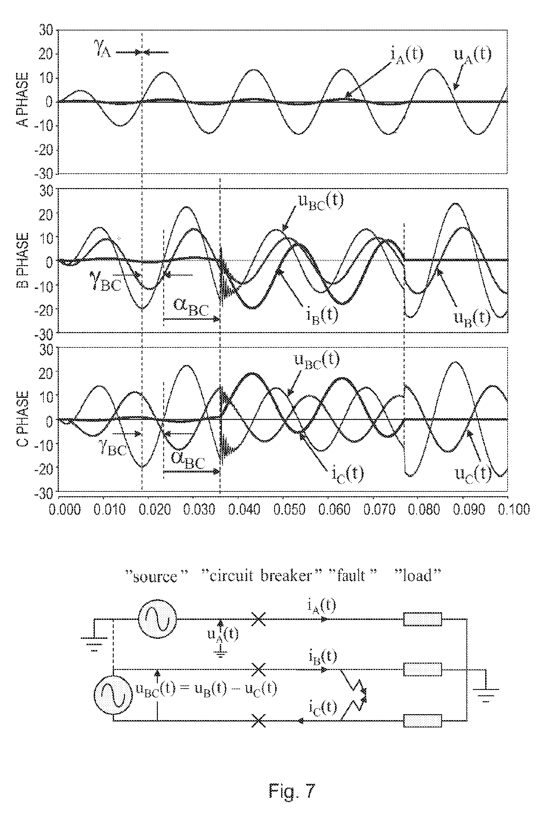

The current change detector 12 is adapted to determining whether or not a fault has occurred in the current path based on changes in the values of either the C1 or C2, for example using the same trend analysis method described in Fig 7 of WO 2006/043871.

The computation unit 5 is informed about the fact that a fault has occurred. The computation unit 5 is adapted to adjust the phase shift $\gamma_X$ of the phase-to-ground voltage for the current path and the phase shift $\gamma_{xy}$ of the phase-to-phase voltage between the current paths, upon detecting a fault.

The evaluation module 10 is also adapted to determine the number of phases involved in the fault based on the first comparisons for all current paths and to determine whether or not there is a three-phase fault in case there is a three-phase fault, to interrupt the current of one of the current paths. The evaluation module 10 is also adapted to determine the type of fault based on the first and second comparisons and to determine whether a fault is a 2-phase-to-ground fault or a phase-to-phase without ground fault based on the first and second comparisons. The information about the type of fault is, for example, transferred from the evaluation module to a display unit and displayed to an operator.

The apparatus further comprises a zero crossing estimation unit 14 adapted to estimate possible interruption current zeros for the current paths based on the predicted current. In case there is a three-phase fault, and the current of one of the current paths has been interrupted, the zero crossing estimation unit 14 is adapted to estimate the possible interruption current zeros for the remaining current paths based on the current model and the parameters used for predicting the valid set of current values.

The apparatus further comprises a waiting time estimation unit 16 for calculating the waiting time until issuing a trip command to the circuit breaker. This also requires inputs of the breaker opening time and the targeted arcing time, block 19. Such inputs can be programmed in, but additionally can be updated by measurements from the breaker e.g. auxiliary contact times to indicate changes in the breaker opening time, or measurement of current to check actual arcing times.

The device further comprises an control device 18 adapted to control the action of interruption devices, arranged in the current paths and upon command interrupt the current in the current path, based on the estimated current zero crossings in order to optimize the current interruption.

The system continuously samples data and updates its prediction of future target current zero times and associated waiting times. While the current model is specifically aimed at asymmetrical fault currents, it can also be used for normal resistive or reactive load currents. The current modeling estimation calculations are described further below.

For a symmetrical multi-phase system driving source "x" voltage, the phase-to-ground voltage $u_x(t)$, can be described in a general form by equation 1,

$$u_x(t) = U_{PKx} \cdot \sin(\omega t + \alpha_x + \gamma_x) \qquad (1)$$

Where,

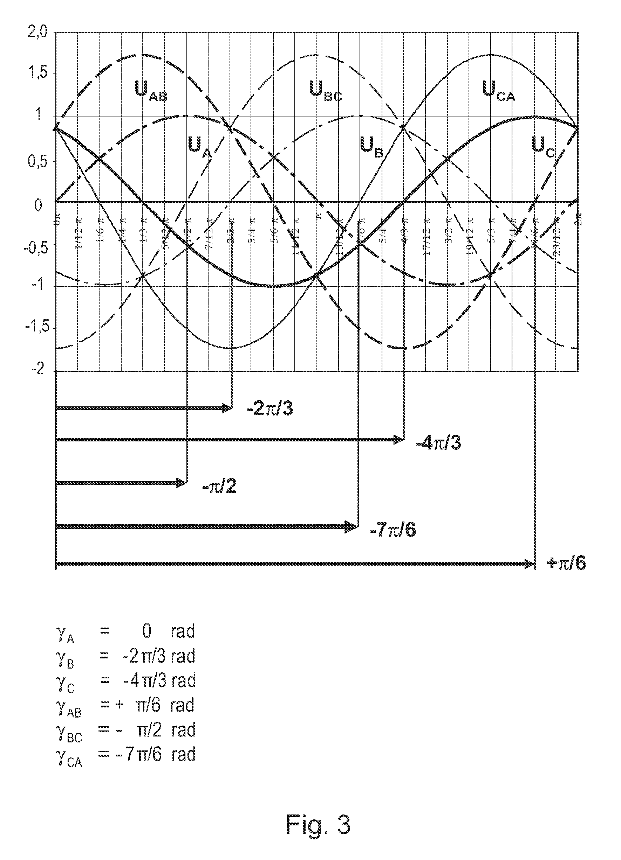

$U_{PKx}$ is the peak voltage,
$\omega$ is the angular frequency,
t is time,
$\alpha_x$ is the angle on the voltage at which the fault starts (corresponding to time t = 0), and
$\gamma_x$ is the phase shift of the phase with respect to the reference time frame vector, e.g. for a three phase symmetrical system, $\gamma_A = 0$ ("reference" phase), $\gamma_B = -2\pi/3$, $\gamma_C = -4\pi/3$ for a phase-to-ground voltage, as shown in figure 3.

The phase-to-phase voltage $u_{xy}(t)$, can be described by equation 2,

$$u_{xy}(t) = U_{PKxy} \cdot \sin(\omega t + \alpha_{xy} + \gamma_{xy}) \qquad (2)$$

Where,
$U_{PKxY}$ is the peak voltage,
$\alpha_{xy}$ is the angle on the phase-to-phase voltage at which the fault starts, and
$\gamma_{xy}$ is the phase shift of the phase with respect to the reference time frame vector, e.g. for a three phase symmetrical system, $\gamma_{AB} = +\pi/6$ ("reference" phase), $\gamma_{BC} = -\pi/2$, $\gamma_{CA} = -7\pi/6$ for phase-to-phase voltages, as shown in figure 3.

Based on the phase-to-ground voltage defined in the form of equation 1, the associated phase-to-ground current, $i_x(t)$, in conductor "x" can be described by equation 3:

$$i_x(t) = I_{FPKx}.[ \sin(\omega t + \alpha_x - \phi_x + \gamma_x) - \sin(\alpha_x + \gamma_x - \phi_x). e^{(-t/\tau x)}] + \quad (3)$$
$$I_{PF\alpha x}. e^{(-t/\tau x)}$$

Where,

t=time

$I_{FPKx}$ is the peak value of the current

$\omega$ is the system angular frequency

$\phi_x$ is the phase angle of the fault current

$\alpha_x$ is the angle on the associated phase-to-ground voltage at which the fault starts (corresponding to time t = 0)

$\gamma_x$ is the phase shift of the associated phase-to-ground voltage with respect to a reference time frame vector,

$\tau_x = L_x/R_x$ is the driving source-to-fault inductance ($L_x$) - to - resistance ($R_x$) ratio.

Based on the phase-to-phase voltage defined in the form of equation 2, the associated current, $i_{xy}(t)$, in conductor "x" and "y" during a phase-to-phase ungrounded fault can be described by equation 4:

$$i_{xy}(t) = I_{FPKx}.[ \sin(\omega t + \alpha_{xy} - \phi_x + \gamma_{xy}) - \sin(\alpha_{xy} + \gamma_{xy} - \phi_x). e^{(-} \quad (4)$$
$$^{t/\tau x)}] + I_{PF\alpha x}. e^{(-t/\tau x)}$$

Where,

$\alpha_{xy}$ is the angle on the associated phase-to-phase voltage at which the fault starts,

$\gamma_{xy}$ is the phase shift of the associated phase-to-phase voltage with respect to the reference time frame vector.

The proposed algorithm is based on determination of the characteristic parameters of the current model described by the above equation. The key unknown characteristic parameters to be determined in equation 3 and 4 include $\alpha$, $\phi$, $\gamma$ and $\tau$. It is clear that $\phi$ and $\tau$ are related through L, R and $\omega$. For the short time transient durations that the parameters must be calculated it is assumed that the power system frequency is constant.

Various methods could be applied to try and ascertain the unknown characteristic parameters, e.g. Kalman filter techniques, Gaussian elimination techniques, etc. What has been selected and found to be suitable is a method based on least mean square regression analysis. Advantages of Least Mean Square based algorithms, in the following denoted LMS include: flexibility to data window sizes, tolerance to noise and relatively straightforward mathematics.

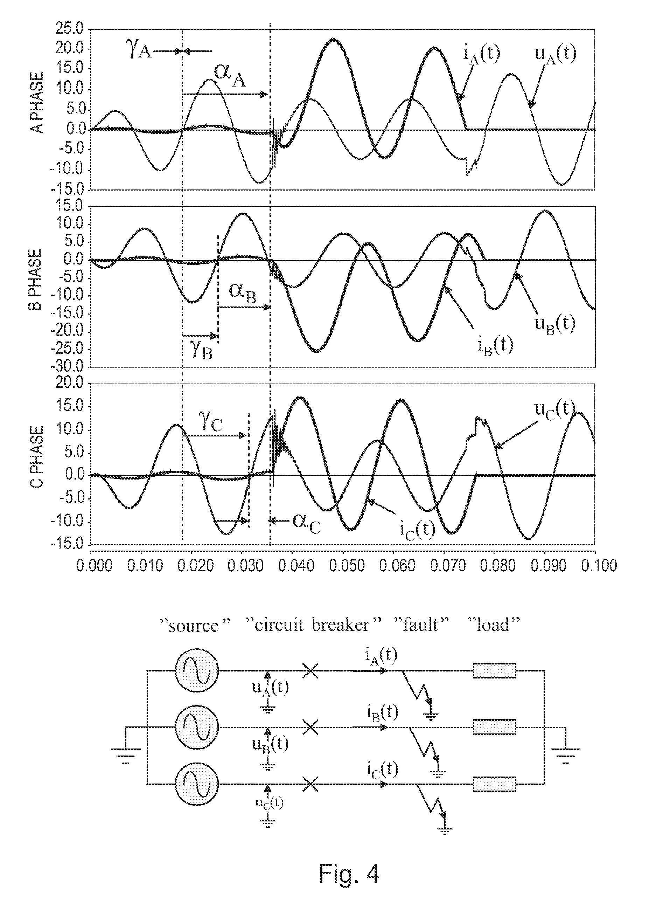

Figures 4, 5, 6 and 7 show examples of different multiple phase fault current interruption cases that can arise in a three-phase alternating current power system and for which the proposed invention provides a solution.

Figure 4 shows an example of interruption of a three-phase fault to ground, i.e. a phase-to-ground type of fault. Phase "A" is taken as the "reference" phase in this example, meaning that the phase shift $\gamma_A = 0$ for time t = 0. The phase shift $\gamma_B$, $\gamma_C$ parameters for phases "B" and "C" are set with reference to phase "A". The proposed algorithm utilizes the $\gamma$ and $\alpha$ parameter values as inputs for estimating the other characteristic parameter values such as $\phi$, $\tau$ and IFPK for each phase current and generating the model of the current and then estimating future target interruption current zero times. As this example is for a fault involving ground connection from the source, and on each faulted phase, each of the currents is interrupted at a current zero time independent of the other phases.

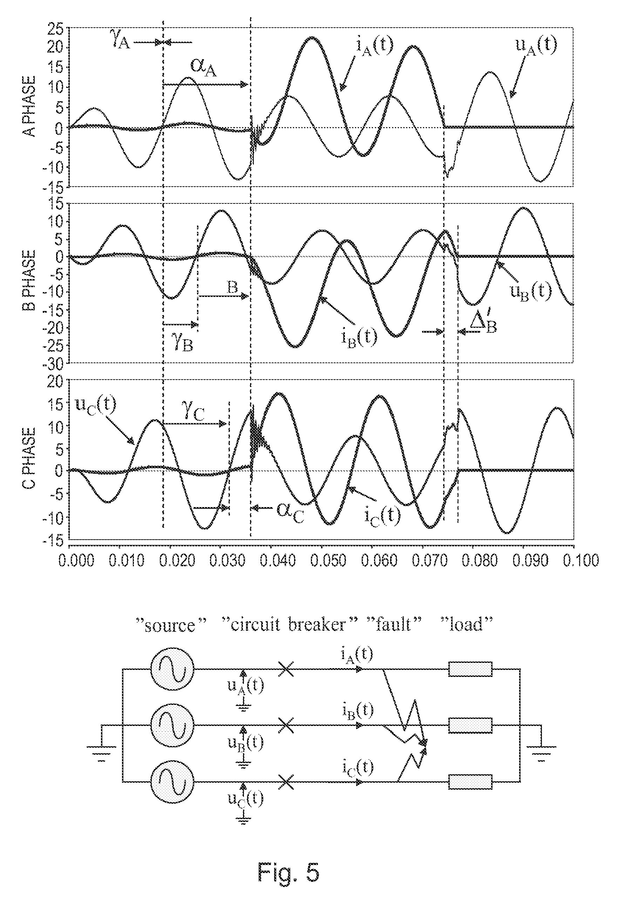

Figure 5 shows an example of interruption of a three-phase fault without ground connection, i.e. a phase-to-phase type of fault. The phase shift $\gamma_A$, $\gamma_B$, $\gamma_C$ and phase angle $\alpha_A$, $\alpha_B$, $\alpha_C$, parameter values are the same as for the example shown in figure 4, and the currents have identical behavior as in the example shown in figure 4, up until the first of the phase currents is interrupted in this case phase "A". Since there is no ground connection in the fault location, the remaining two uninterrupted phases must shift their currents to maintain symmetry since in the absence of an ground connection, the sum of all currents in a symmetrical system must always be zero. As such, the currents in the as yet uninterrupted phases shift into phase opposition, is similar to a phase-to-phase fault condition. $\Delta_B$' is the phase shift in the last phases to interrupt, after the first phase is interrupted.

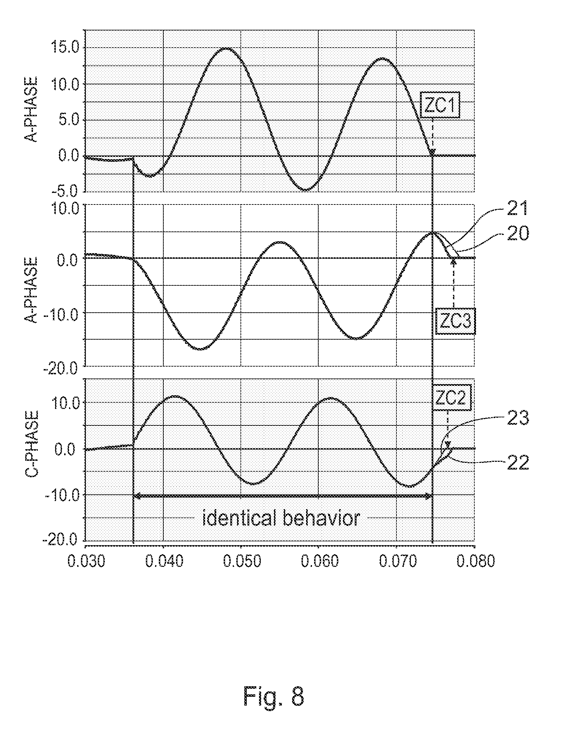

The main control problem in this case is that the behavior of the currents in all phases, before the first phase current is interrupted, is identical i.e. it is not possible to differentiate between a three phase grounded fault, i.e. a phase-to-ground fault, and a three phase ungrounded fault, i.e. a phase-to-phase fault, before the first phase interrupts and it is not acceptable to wait for the first phase to interrupt to adjust the control of the last phases to interrupt since the fault must be interrupted as quickly as possible. The proposed invention solves this problem by implementing a compromise targeting solution for the last phases to interrupt. The invention identifies the first phase to interrupt and then for the remaining phases estimates their possible interruption current zeroes for both the grounded and ungrounded cases. The invention then selects the earliest current zero in each phase as the target for that phase. At least one of these current zeroes will be correct for a given phase and while the other phase will experience a slightly longer than expected arcing time. The longer arcing time in the non-optimized phase shall be within the target arcing time margin of the circuit breaker. This is illustrated in figure 8. In the figure, the A-phase is interrupted at ZC1. As seen from the figure, the predicted currents for the phase-to-ground 21,23 and the phase-to-phase cases 20,22 for the B-phase and the C-phase are identical until the current in the A-phase is interrupted. After interruption of the current in the A-phase, the current predictions will begin to diverge. The B-phase is interrupted at ZC3 and the C-phase is interrupted at ZC2, which are the earliest predicted current zeros in each of the last phases.

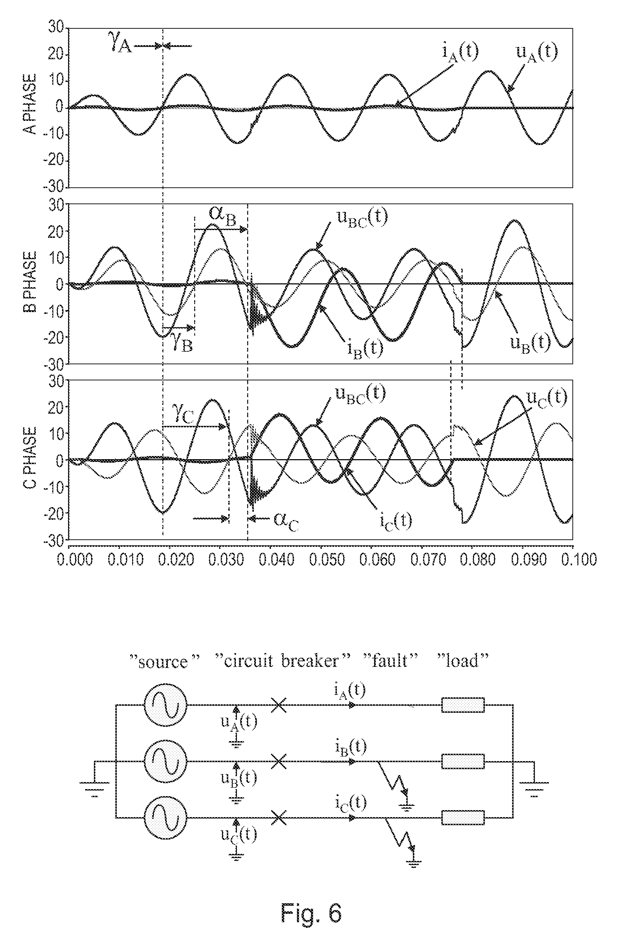

Figure 6 shows an example of a two phase to ground fault. Phase "A" is still the "reference" phase with respect to time, t = 0, and to which the $\gamma$ and $\alpha$ parameter values for the other phases are set. As the fault involves a ground connection, the currents in each of the two faulted phases behave independently.

Figure 7 shows an example of a fault in the same phases and same point in time as for Figure 6, but in Figure 7 the fault is between phases "B" and "C" without a ground connection, i.e. a phase-to-phase type of fault. Since there is no ground connection in this fault case and the sum of currents in the faulted phases must be zero, the effective equivalent circuit for this case is that shown in the figure. Phase "A" is unfaulted and has ground connection at the source, and load and behaves normally. Phases "B" and "C" are connected via the fault and the fault current is driven by the phase-to-phase voltage "$u_{BC}(t)$". In effect phases "B" and "C" are combined by the ungrounded phase-to-phase fault connection into their own single phase "equivalent" circuit with "$u_{BC}(t)$" as the equivalent source voltage. Though phase "A" is still the overall "reference" phase for the invention method, the driving source voltage for this fault case is "$u_{BC}(t)$" and the $\gamma$ and $\alpha$ parameter values for "B" and "C" phases must be adjusted to "$\gamma_{BC}$" and "$\alpha_{BC}$" accordingly.

A novel feature of the proposed method is that the general equation forms for the voltage and current described in equations 1 - 4 are the same for the all fault cases. Only the values of the $\gamma$ and $\alpha$ terms need to be adjusted to manage certain fault types. In particular two main fault groupings need only be considered, faults involving and faults not involving a ground connection. Hence the invention makes calculation of the parameter values for the model of the current for both of these cases and evaluates which of these best matches the actual sampled current values. Only for three phase faults is it necessary to implement the compromise solution for the last phases to interrupt.

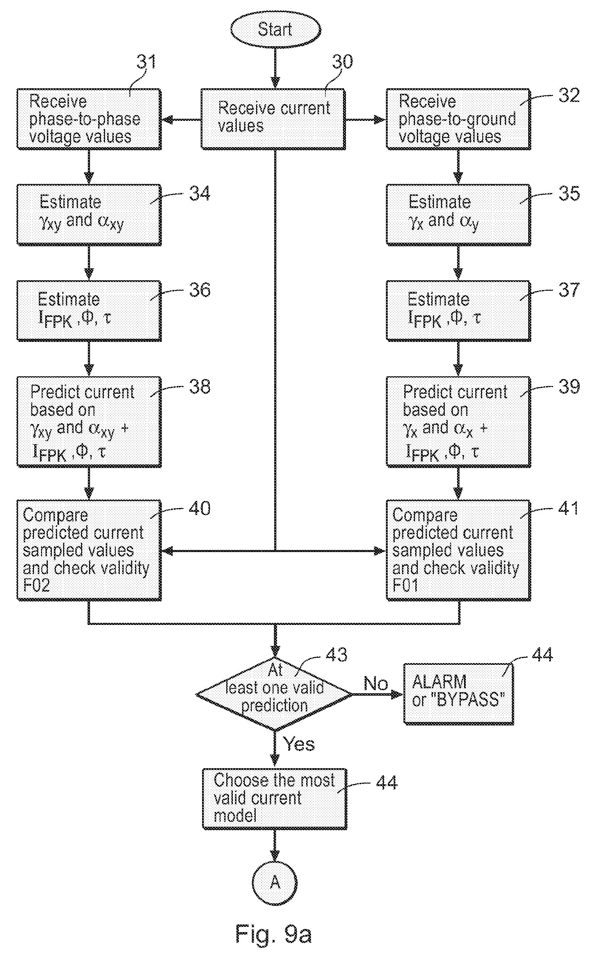

Figure 9a-b is a flow chart illustration of the method and the computer program product according to an embodiment of the present invention. It will be understood that each block of the flow chart can be implemented by computer program instructions. The steps shown in Figures 9a-b are iterated for each phase current, ideally in parallel with each other.

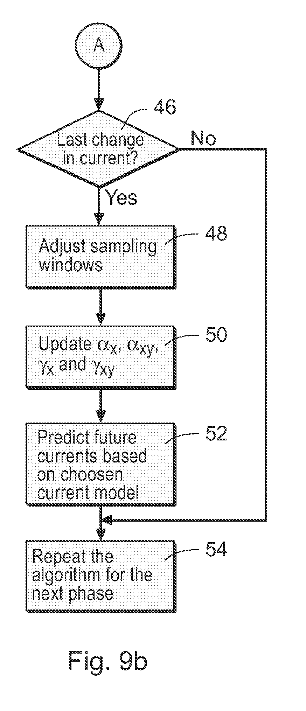

Current measurements in all phases are continuously sampled in moving sampling windows. Voltage measurements in at least one phase are continuously sampled in a moving sampling window. It is enough to measure the voltage in one phase, since it is possible to calculate the voltages in the other phases and between the phases based on voltage measurements of one phase. The algorithm described in figure 9 is repeated for each phase in the system. Necessary input values to the algorithm described in figure 9 are sampling values of the current in the phase, block 30, and sampled or calculated values for the phase-to-ground voltage and sampled or calculated values for the phase-to-phase voltage, block 31,32.

The voltage measurements are used to obtain power system angular frequency $\omega$, frame-of-reference phase shift $\gamma$ and fault initiation phase angle $\alpha$ values. There are potentially several ways to manage this voltage reference aspect. All have in common to tie the voltages to a common time vector frame of reference i.e. have the correct phase shift $\gamma$ values with respect to a common time vector. One method is to simply set "A" phase as the "reference phase" and thus $\gamma_A = 0$ for time t=0. In a symmetrical, balanced network the relative phase shift $\gamma$ values for the other phases should remain fixed with respect to each other, and thus fixed with respect to the A-phase. As such, the method will work by only measuring voltage on one phase e.g. A-phase. One could theoretically also just measure one phase-to-phase voltage and adjust the phase shift $\gamma$ and phase angel $\alpha$ values from there.

One could also measure the phase-to-ground and/or the phase-to-phase voltages and based on common definition of evaluating the phase shift $\gamma$ to the same point on wave for each sinusoidal voltage, e.g. where volts = 0 on rising zero crossing, one could measure the phase shifts with respect to a time t=0. Measuring the voltages also has the benefit of being able to maintain a check on the power system frequency, which actually sets the value of $\omega$ in the equations.

The phase-to-phase voltages can be either measured directly, though more commonly they would be calculated by subtracting relevant phase-to-ground voltages.

Values of the phase-to-ground parameters $\gamma_x$, $\alpha_x$ are estimated based on the values for the phase-to-ground voltage, block 34, and values of the phase-to-phase parameters $\gamma_{xY}$, $\alpha_{xY}$ are estimated based on the values for the phase-to-phase voltage, block 35. The remaining unknown parameter values of the current model, such as the peak value of the current $I_{FPK}$, the driving source-to-fault inductance-to-resistance ratio $\tau$, and the phase angle $\phi$ of the current

are estimated based on the estimated phase-to-phase and phase-to-ground parameters and the values of the current, block 36, 37. The characteristic parameters are, for example, estimated by means of a least means squares method.

The complete set of estimated parameter values is applied to the current models described by equations 3 and 4 to form two estimations of the measured current. A first set of current values is predicted based on the mathematical model of the current described by equation 3, the estimated phase-to-ground parameters $\gamma_x$, $\alpha_x$, and the sampled values of the current, block 39. A second set of current values is predicted based on the mathematical model of the current described by equation 4, the estimated phase-to-phase parameters $\gamma_{XY}$, $\alpha_{XY}$, and the stored sampled values of the current, block 38.

Now it has to be determined whether the model described by equation 3, including phase-to-ground parameters, or the model described by equation 4, including phase-to-phase parameters, is a valid model. This is done by comparing the first and second set of predicted current values with sampled values of the current from the same point in time. This makes it possible to determine whether the first, second or both sets of predicted current values, are valid predictions of the current in the path, block 40 and 41. There are several established statistical methods applied in linear regression to verify the suitability or correlation of a model to sampled data. Most such tests are derived from analysis of the residuals between the model function and the sampled data set. A known test for linear regression models is the so-called "F0 hypothesis test", otherwise referred to as "test for significance of regression", as described by Montgomery Douglas C., and Runger George C., in "Applied Statistics and Probability for Engineers", 2nd Edition, John Wiley & Sons, Inc., New York, 1999.

The measured and estimated current values are compared (over a common time range) to verify the accuracy of the estimated model current, e.g. using error analysis, statistical correlation or analysis of variance. Such comparisons, for the phase-to-ground and phase-to-phase parameter set current models result in values, e.g. "F01" and "F02" that can then be compared to ascertain which parameter set should be used for extrapolation of future current behavior. Based on the "F01" and "F02" values it is also possible to determine whether any of the predicted currents is a valid prediction, block 43. If none of the predicted set of currents is found to be valid, there is either a fault in the current, which cannot be predicted, then the previously described "by-pass" route can be used, or there is a fault in the measuring and calculation equipment and then, for example, an alarm can be generated.

If one of the sets of predicted current value is found to be valid, the model including the parameters used for predicting the valid set of current values is used for extrapolation of future current behavior. If both set of predicted current values are found to be valid, the model including the parameters used to predict the most valid current prediction is chosen based on a comparison between "F01" and "F02" and used for extrapolation of future current behavior, block 44.

The measured versus estimated current value comparison results, e.g. "F01", "F02", can also be used for detecting a change in the current, such as detection of a fault transient, block 46. If a large change in the current is detected, the sampling windows are adjusted such that current data from a point in time before the change are discarded, block 48, the values of the phase angel $\alpha$ and phase shift $\gamma$ are updated, as described in WO 2006/043871 (see Figure 7 of same), block 50, and future values of the current of the path is predicted predicting based on the updated parameters, block 52.

At start up, for example when the breaker is first driven closed on to the system, the calculation of the phase shift $\gamma$ can be done so that the three phases close in synchronization, i.e "t = 0", for example, with A-phase voltage rising zero and thereby with $\alpha_A$ and $\gamma_A$ equal to zero and the other $\alpha$ and $\gamma$ values for the other phases adjusted with respect to A-phase as the reference.

At start up also, the phase-to-phase $\alpha$ and $\gamma$ values are set to same as the phase-to-ground $\gamma$ and $\alpha$ values, so that the left hand side and right hand side of Fig 9a-b should come to the same estimated $\phi$ and other parameter values and the same estimated currents. Hence the F01 and F02 values will be the same, until a fault occurs. If the fault is a two phase, phase-to-phase fault without ground, then the F02 result will ultimately be higher than the F01 result, after the adjustment of the alpha and gamma values for the left hand side of Fig 9a-b flowchart.

If the estimated current is found to be sufficiently accurate it is extrapolated to find the next viable future current zero(es) for which interruption could occur. The system can select the most desirable current zero(es) based on pre-selected criteria including, for example, fastest interruption time, maximum arc integral savings, or preferred di/dt rate.

A waiting time for delaying a trip signal to the circuit-breaker is calculated based on the identified target interruption current zero, circuit-breaker opening and targeted arcing times

Once the waiting time is zero and the associated protection (and/or control) system has determined the breaker shall be tripped, the trip command(s) are sent to the circuit-breaker(s)

Additional features are built into the above system to detect fault start, fault type detection, i.e. 1 / 2 / 3 phase-to-ground or phase-to-phase, select target current zero based on either earliest possible interruption or lowest arc integral stress, compromise current zero estimation for last phases to interrupt on non-effectively grounded systems and control supervision to permit bypassing of synchronizing control in event acceptable current estimation modeling cannot be achieved within the protection system activation time.

Once a fault occurs, it depends on what type of fault, on how the gamma and alpha values will change. The occurrence of the fault will mean that the measured and estimated currents will start to diverge. This will be detected by the F0-trend function check, which for simplicity in practice is only tracked using the F01 values in each phase. Once the algorithm detects a fault it will discard the prefault data, based on its estimation from the F01 trend function of the instant the fault started and start collecting data from the fault start point in time. The algorithm will also update its values for $\alpha$ for phase-to-ground and phase-to-phase, based on the fault start instant.

The $\gamma$ values for the left hand side will not change, as the phase-to-ground values are always "valid" in a general sense, but potentially not "relevant", for example if it turns out to be a phase-to-phase fault. The phase-to-phase gamma and alpha values are then adjusted based on which two phases are involved in the fault, only in the case where two phases only are involved.

The number of phases involved in any fault is easily determined by checking which F01 values "trigger" to a fault event. Only the F01's on the fault phases will "react". Hence, one gets from this if the fault is 1-phase, 2-phase or 3-phase. We need to compare F01 and F02 outcomes again in the event of 2-phase faults to discriminate between 2-phase to ground and phase-to-phase without ground faults.

It is not really worth trying to adjust phase-to-phase $\gamma$ and $\alpha$ values before a fault occurs, as it is not know if the next fault it just 2-phase or not and in the case of a phase-to-phase fault. For any one phase there can be two possible combinations e.g. assume we adjust $\gamma$ and $\alpha$ values for fault in "A" phase with one other phase. Maybe it is an "AB" fault, or "AB-E" or "CA" or "CA-E" fault.

The gamma and alpha values for "XX" faults are different from that for "XX-E" faults. Furthermore, from the above example, the gamma and alpha values for "AB" fault are not the same as for a "CA" fault.

Based on the identification of which phases are involved in such a two-phase fault, the phase-to-phase $\gamma$ and $\alpha$ values are appropriately adjusted. These adjustments are "fixed" in the sense that the values are known for a symmetrical three phase system, but we simply do not know which ones to use before the fault actually occurs.

The "default" (start-up) input $\gamma$ values assume the "XX-E" case is more likely and than the "XX" case and so the right hand side of figure 9 will come to correct solution.

When the phase-to-phase fault occurs, the algorithm makes parallel calculation, right hand side Fig 9a-b assuming "XX-E" case, leading to an F01 result and the left hand side Fig 9a-b assuming "XX" case, leading to F02 result. If the F02 result is greater than the F01 result then we know it is a "XX" case and make further predictions on that basis.

What follows is a more detailed description of the application of the least means squares regression method as one possible means of determining parameter values for a given current model. As mentioned previously other methods e.g. Kalman filtering could also be applied to the same purpose or function.)

Equation (3) can be orthogonally factorized as per (5),

$$i_x(t) = K_{x1}.\sin(\omega t) + K_{x2}.\cos(\omega t) - K_{x2}.\ e^{(-t.\ Kx3)} + I_{PF\alpha x}.\ e^{(-t.\ Kx3)} \qquad (5)$$

where

$$K_{x1} = I_{Fx}\ .\ \cos(\alpha_x + \gamma_x - \phi_x) \qquad (6)$$

$$K_{x1} = I_{Fx}\ .\ \cos(\gamma_x - \phi_x).\cos(\alpha_x) - I_{Fx}\ .\ \sin(\gamma_x - \phi_x).\sin(\alpha_x) \qquad (7)$$

$$K_{x2} = I_{Fx}\ .\ \sin(\alpha_x + \gamma_x - \phi_x) \qquad (8)$$

$$K_{x2} = I_{Fx} \cdot \sin(\gamma_x - \phi_x).\cos(\alpha_x) + I_{Fx} \cdot \cos(\gamma_x - \phi_x).\sin(\alpha_x) \qquad (9)$$

$$K_{x3} = 1 / \tau_x \qquad (10)$$

Neglecting the pre-fault current term and using a 1st order Taylor series approximation for the exponential term, equation (5) can then be further approximated to (11),

$$i_x(t) \approx X_{x1}.\sin(\omega t) + X_{x2}.\cos(\omega t) - X_{x3}.1 + X_{x4}.t \qquad (11)$$

The $X_x$ coefficients in (11) can then be found from applying the least means squares matrix method, as described by (12), (13) and (15),

$$\begin{bmatrix} X_{x1} \\ X_{x2} \\ X_{x3} \\ X_{x4} \end{bmatrix} = \left([A]^T \bullet [W]^T \bullet [W] \bullet [A]\right)^{-1} \bullet [A]^T \bullet [W]^T \bullet [W] \begin{bmatrix} ifx(t_1) \\ ifx(t_2) \\ \vdots \\ ifx(t_n) \end{bmatrix} \qquad (12)$$

where n is the number of current data sample values processed,

$$[A] = \begin{bmatrix} \sin(\omega t_1) & \cos(\omega t_1) & -1 & t_1 \\ \sin(\omega t_2) & \cos(\omega t_2) & -1 & t_2 \\ \vdots & \vdots & \vdots & \vdots \\ \sin(\omega t_n) & \cos(\omega t_n) & -1 & t_n \end{bmatrix} \qquad (13)$$

$$[W] = \begin{bmatrix} 1 & 0 & 0 & 0 \\ 0 & 1 & 0 & 0 \\ \vdots & \vdots & \ddots & \vdots \\ 0 & 0 & 0 & 1 \end{bmatrix} \qquad (14)$$

and $[X_{x1}\ X_{x2}\ X_{x3}\ X_{x4}]^T$ is the vector of unknown coefficients sought.

The key results from the solution of (12) are terms $X_{x1}$ and $X_{x2}$ which are in the general forms given by (15) and (16),

$$X_{x1} = I_{Fx} \cdot \cos(\gamma_x - \phi_x) \tag{15}$$

$$X_{x2} = -I_{Fx} \cdot \sin(\gamma_x - \phi_x) \tag{16}$$

The $X_{x1}$ and $X_{x2}$ terms provide the orthogonal terms of the symmetrical component of the sampled current, while the $X_{x3}$ and $X_{x4}$ terms provide a linearized approximation of the asymmetrical (general) component of the sampled current.

The frame of reference to the respective driving source voltage for each associated current is managed by the $\gamma_x$ terms included in the factorization of (5).

Knowing $\alpha_x$ and $\gamma_x$ it is possible to derive, in phase specific terms, $K_{x1}$ and $K_{x2}$, by (17) and (18),

$$K_{x1} = X_{x1}.\cos(\alpha_x) + X_{x2}.\sin(\alpha_x) \tag{17}$$

$$K_{x2} = X_{x1}.\sin(\alpha_x) - X_{x2}.\cos(\alpha_x) \tag{18}$$

$K_{X3}$ is found directly by using $X_{x1}$ and $X_{x2}$ as per (19),

$$K_{x3} = 1\ /\ |X_{x2}/X_{x1}|\ /\ \omega \tag{19}$$

The $K_x$ terms, $\gamma_x$ and $I_{PF}\alpha x$ can then be applied to (5) to obtain an approximation of the sampled currents in each phase. These approximations can in fact be extrapolated in time and hence be used for estimated future current zero times that can be used as targets for controlled fault interruption.

The above method can equally well be applied to ungrounded phase-to-phase faults, for example by adjusting the $\gamma_x$ and $\alpha_x$ values to be with respect to the associated phase-to-phase source voltage for such a two phase fault.

The data sampling window management, estimated current correlation / analysis-of-variance check ("F0 check"), "F0-trend" fault inception detection ($\alpha_x$ detection) and target current zero time estimation steps applied to this method are essentially the same as described in patent application PCT/SE2005/001508, but applied on all three phases.

All of the method steps, as well as any sub-sequence of steps, described with reference to the figure 9a-b above may be controlled by means of a programmed computer apparatus. Moreover, although the embodiments of the invention described above with reference to the drawings comprise computer apparatus and processes performed in computer apparatus, the invention thus also extends to computer programs, particularly computer programs on or in a carrier, adapted for putting the invention into practice. The program may be in the form of source code, object code, a code intermediate source and object code such as in partially compiled form, or in any other form suitable for use in the implementation of the process according to the invention.

The term comprises/comprising when used in this specification is taken to specify the presence of stated features, integers, steps or components. However, the term does not preclude the presence or addition of one or more additional features, integers, steps or components or groups thereof.

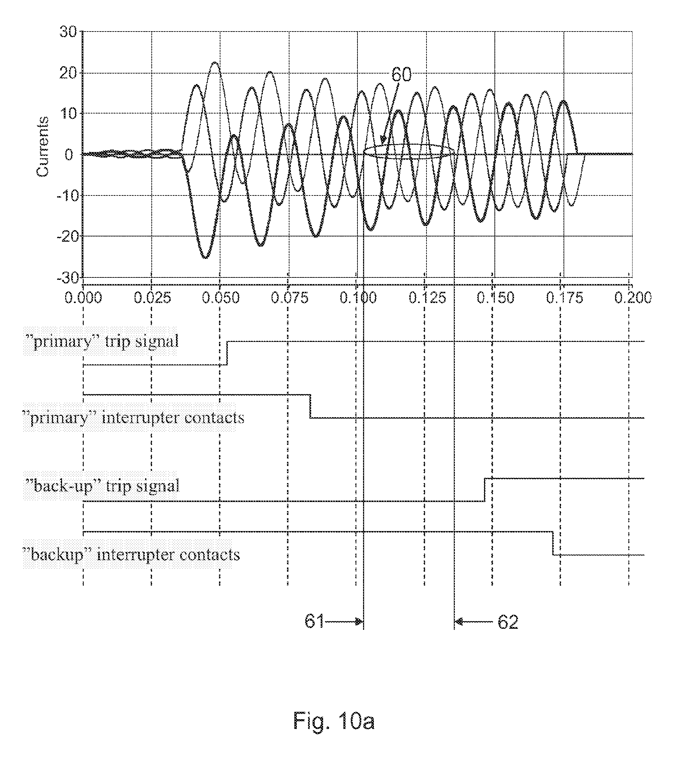

The method is also enables improved, i.e. faster, breaker failure detection by simply anticipating at which current zero a directly tripped, i.e. non targeted or non synchronized tripped, breaker should interrupt in each phase or current path. Figure 10a illustrates the uncertainty margin on when the primary interrupter will interrupt the currents in the paths when no predictions of the current and the current zeros are made. If no prediction of the current zeros is made, it is not possible to predict with certainty when the primary interrupter should interrupt. The area 60 in the figure 10a shows possible currents zeros at which the interrupter may brake the current. The arrows 61 and 62 indicate the uncertainty margin on when the primary interrupter will interrupt without current zero prediction.

Today no such accurate prediction is made, with the result that only a rough approximation of the maximum expected current interruption time is made. So called back-up protection schemes and back-up tripping operations are made when current is still detected to be flowing in current paths after the roughly estimated expected maximum interruption times. The roughness of the maximum expected interruption time, leads to longer delay in interruption of fault currents if the first interruption device expected to achieve interruption, fails (for some reason) to do so. Hence the fault remains overall longer on the power network increasing the risk that the power network will become unstable (due to the difficulty in sustaining the high fault currents for long times) and leading to a so-called "collapse" of the power network and large scale power loss or blackouts.

Alternative methods for all or parts of the described process can be used, whereby the current can be modeled as a function with various parameters and such parameters determined by various methods, still resulting in a model of the current that is used for predicting its future behavior and for example predicting future current zero crossing times that are then used for synchronizing trip commands in order to achieve preselected arcing times, e.g. note Kalman filtering techniques for phase angle estimation or artificial neural networks for fault type classification e.g. as applied in some modern digital protection relays.

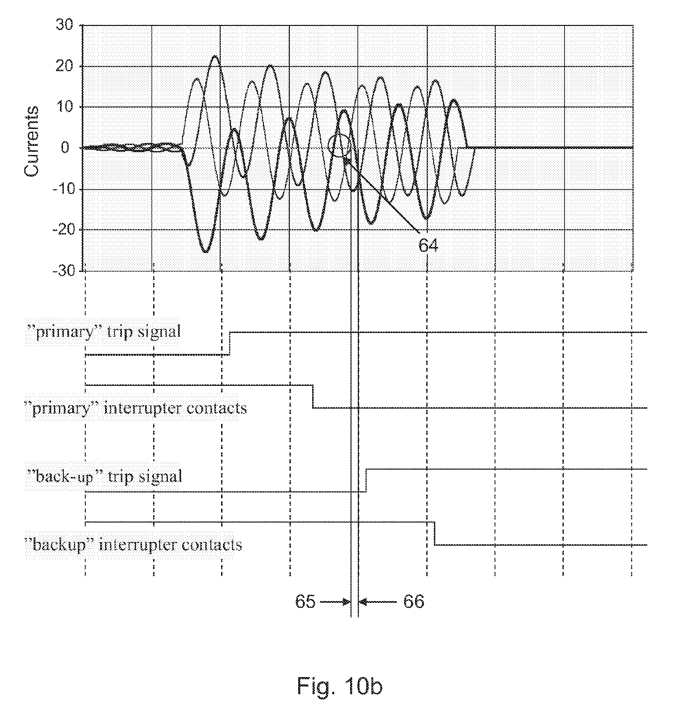

The proposed method can accurately predict the expected interruption current zero times and thereby reduce the buffer time margin allowed for the back up protection or back tripping and reducing the overall fault duration time in the event the first interrupter fails to interrupt and thereby reducing the risk of large scale blackouts due to the failure of an interrupter. Fig. 10b illustrates the uncertainty margin on when the primary interrupter will interrupt the currents in the paths using current zero prediction based on the method according to the invention. If a prediction of the current and the current zeros in the paths are made, it is possible to predict with a reasonable certainty when the primary interrupter should interrupt. The area 66 in the figure 10b shows possible currents zeros at which the interrupter may brake the current. The arrows 65 and 66 indicate the uncertainty margin on when the primary interrupter will interrupt with current and current zero predictions according to the invention. As seen from figure 10a and 10b, the uncertainty margin is considerably reduced if the current and current zeros are predicted with a method according to the invention.

**Claims**

1. A method for predicting the future behavior of current(s) in current paths forming phases in a multi-phase alternating current electrical power system, the method comprising:

    - continuously saving sampled values of the voltage (v(t)) for at least one of said current paths,
    - continuously saving sampled values of the current (i(t)) for each of the current paths,

    **characterized in that** the method further comprises for each of the current paths:

    - estimating one or more phase-to-ground parameters for the voltage of the current path based on the stored values of the voltage,
    - predicting a first set of current values based on a mathematical model of the current, the estimated phase-to-ground parameters, and the sampled values of the current,
    - performing a first comparison between said first set of predicted current values and sampled values of the current from the same point in time,
    - estimating one or more phase-to-phase parameters for the voltage of the current path based on the stored values of the voltage,
    - predicting a second set of current values based on said mathematical model of the current, the estimated phase-to-phase parameters, and the stored sampled values of the current,
    - performing a second comparison between said second set of predicted current values and sampled values of the current from the same point in time,
    - determining whether the first or second set of predicted current values is a valid prediction of the current in the path based on the results of said first and second comparison, and

- if any of the first or second set of predicted current value is found to be valid, predicting future values of the current of the path based on said model and the parameters used for predicting the valid set of current values.

2. The method according to claim 1, wherein said phase-to-ground parameters include the phase shift ($\gamma_x$) of a phase-to-ground voltage ($v_x(t)$) for the current path with respect to a reference phase and said phase-to-phase parameters include the phase shift ($\gamma_{xy}$) of a phase-to-phase voltage ($v_{xy}(t)$) between the current paths with respect to a reference phase.

3. The method according to claim 1 or 2, wherein said phase-to-ground parameters include the phase angle ($\alpha_x$) of a phase-to-ground voltage ($v_x(t)$) for the current path and said phase-to-phase parameters include the phase angle ($\alpha_{xy}$) of a phase-to-phase voltage ($v_{xy}(t)$) between the current paths.

4. The method according to any of the previous claims, wherein it comprises calculating the deviation between the first and second comparison and based thereon determining whether or not a change in current has occurred in the current path.

5. The method according to claim 2, wherein the method comprises: adjusting the estimated phase shift ($\gamma_{xy}$) of the phase-to-phase voltage and the estimated phase shift ($\gamma_x$) of the phase-to-ground voltage upon detecting that a change in the current has occurred in the current path.

6. The method according to claim 3, wherein the method comprises: upon detecting that a change in the current has occurred in the current path, determining the point in time when the change in current started, and estimating the phase angle ($\alpha_x$) of the phase-to-ground voltage and the phase angle ($\alpha_{xy}$) of the phase-to-phase voltage at the point in time when the change in current started based on said sampled values of the voltage.

7. The method according to any of the previous claims, wherein said sampled values of the current ($i(t)$) for a current path are stored in a moving window, and the method further comprises: upon detecting that a change has occurred in the current in the current path, the moving window for the current is adjusted to discard current values prior to the change in current, and predicting future values of the current based on the present values in the adjusted moving window.

8. The method according to any of the previous claims, wherein the method comprises estimating one or more characteristic parameters for the current based on the stored sampled values of the current and the estimated phase-to-ground parameters for the voltage, and predicting future values of the current based on the mathematical model of the current, the estimated phase-to-ground parameters, and the characteristic parameters for the current.

9. The method according to any of the previous claims, wherein the method comprises determining whether or not a fault has occurred in the current path based on the deviation between the first and second comparison, and determining which of the phases are involved in the fault based on said first comparisons for all current paths.

10. The method according to claim 9, wherein the method comprises determining whether or not there is a three-phase fault, and in case there is a three-phase fault: estimating the time of the current zero for the first phase to interrupt, estimating possible interruption current zeros for the remaining two current paths based on said model and both the phase-to-ground and the phase-to-phase parameters, and selecting for interruption the earliest of the estimated current zeros in each of the remaining paths.

11. The method according to any of the previous claims, wherein the method comprises determining whether or not a fault has occurred in the current path based on the deviation between the first and second comparison, and determining whether there is phase-to-phase or a phase-to-ground fault based on said first and second comparisons.

12. The method according to any of the previous claims, wherein the method comprises estimating one or more future zero crossings (Z1 - Z5) of the fault current based on the predicted future values of the current, and based on the estimated zero crossings controlling the action of an interruption device arranged in the current path for interrupting the current upon command, in order to optimize the current interruption.

13. The method according to any of the previous claims, wherein the method comprises estimating expected interruption current zero times in all phases for an interrupter and in the event of the interrupter failing to interrupt in any or all phases, providing a signal to a back-up protection or back-up interrupter to complete the current interruption process.

14. A computer program product directly loadable into the internal memory of a computer, comprising software for performing the steps of any of the claims 1 - 13.

15. A computer-readable medium, having a program recorded thereon, where the program is to make a computer perform the steps of any of the claims 1-13, when said program is run on the computer.

16. An apparatus for predicting the future behavior of current(s) in current paths (1a-c) forming phases in a multi-phase alternating current electrical power system, the apparatus comprising:

- a first member (3) adapted to continuously sample the voltage (v(t)) for at least one of said current paths and to save the sampled values of the voltage,
- a second member (2) adapted to continuously sample the current (i(t)) for each of the current paths, and to save the sampled values of the currents.

**characterized in that** the apparatus further comprises:

- a computation unit (5) adapted estimate phase-to-ground parameters and phase-to-phase parameters for the voltage of each current path based on the stored values of the voltage,
- a predictor arrangement (6) adapted to predict a first set of current values for each current path based on a mathematical model of the current, the estimated phase-to-ground parameters, and the sampled values of the current, and to predict a second set of current values for each current path based on said mathematical model of the current, the estimated phase-to-phase parameters, and the stored sampled values of the current,
- a comparator (8) adapted to perform a first comparison between said first set of predicted current values and sampled values of the current from the same point in time, and to perform a second comparison between said second set of predicted current values and sampled values of the current from the same point in time, and
- an evaluation module (10) adapted to determine whether the first or second set of predicted current values is a valid prediction of the current in the path based on the results of said first and second comparison, and if any of the first or second set of predicted current value is found to be valid, the predictor arrangement is adapted to predict future values of the current of the path based on the parameters used for predicting the valid set of current values.

17. The apparatus according to claim 16, wherein said phase-to-ground parameters include the phase shift ($\gamma_x$) of a phase-to-ground voltage ($v_x(t)$) for the current path with respect to a reference phase and said phase-to-phase parameters include the phase shift ($\gamma_{xy}$) of a phase-to-phase voltage ($v_{xy}(t)$) between the current paths with respect to a reference phase.

18. The apparatus according to claim 16 or 17, wherein said phase-to-ground parameters include the phase angle ($\alpha_x$) of a phase-to-ground voltage ($v_x(t)$) for the current path and said phase-to-phase parameters include the phase angle ($\alpha_{xy}$) of a phase-to-phase voltage ($v_{xy}(t)$) between the current paths.

19. The apparatus according to any of the claims 16 - 18, wherein the apparatus comprises a current change detector (12) adapted to calculate the deviation between the first and second comparison and based thereon determining whether or not a change in the current has occurred in the current path.

20. The apparatus according to any of the claims 16 - 19, wherein the computation unit (5) is adapted to upon detecting that a change in current has occurred in the current path, determine the point in time when the change in current started, and to estimate the phase angle ($\alpha_x$) of the phase-to-ground voltage and the phase angle ($\alpha_{xy}$) of the phase-to-phase voltage at the point in time when the change in current started based on said sampled values of the voltage.

21. The apparatus according to any of the claims 16 - 20, wherein said second member (2) is adapted to store sampled values of the current (i(t)) in a moving window, and the predictor arrangement unit is adapted to discard current values prior to a change in current, and to predict future values of the current based on current values sampled after the change in current.

22. The method according to claim 19, wherein the current change detector (12) is adapted to determining whether or not a fault has occurred in the current path based on the deviation between the first and second comparison, and the evaluation module is adapted to determine which of the phases is involved in the fault based on said first comparisons for all current paths.

23. The apparatus according to claim 22, wherein the apparatus comprises a zero crossing estimation unit (14) adapted to estimate possible interruption current zeros for the current paths, and said evaluation module is adapted to determine whether or not there is a three-phase fault, and in case there is a three-phase fault, to estimate the time of the next current zero for the first phase to interrupt, to estimate possible interruption current zeros for the remaining two current paths based on said model and both the phase-to-ground and the phase-to-phase parameters, and to select for interruption the earliest of the estimated current zeros in each of the remaining paths.

24. The apparatus according to any of the claims 16 - 23, wherein said current change detector (12) is adapted to determine whether or not a fault has occurred in the current path based on the deviation between the first and second comparison, and the evaluation module is adapted to determine whether there is phase-to-phase or a phase-to-ground fault based on said first and second comparisons.

25. The apparatus according to any of the claims 16 - 24, wherein the evaluation module (10) is adapted to determine whether a fault is a 2-phase-to-ground fault or a phase-to-phase without ground fault based on said first and second comparisons.

26. Use of the apparatus according to any of the claims 16 - 25 for predicting current zeroes of an asymmetrical fault current in a multi-phase alternating current electrical power system.

27. Use the apparatus according to claims 16-25 for predicting expected interruption current zero times in all phases for an interrupter and in the event of the interrupter failing to interrupt in any or all phases, providing a signal to a back-up protection or back-up interrupter to complete the current interruption process.

**Amended claims in accordance with Rule 137(2) EPC.**

1. A method for predicting the future behavior of current(s) in current paths forming phases in a multi-phase alternating current electrical power system, the method comprising:

- continuously saving sampled values of the voltage ($v(t)$) for at least one of said current paths,
- continuously saving sampled values of the current ($i(t)$) for each of the current paths,

**characterized in that** the method further comprises for each of the current paths:

- estimating one or more phase-to-ground parameters, such as the phase angle ($\alpha_x$), for the phase-to-ground voltage ($v_x(t)$) of the current path based on the stored values of the voltage,
- predicting a first set of current values based on the estimated phase-to-ground parameters, the sampled values of the current, and a mathematical model of the current including one or more characteristic parameters, which parameters have different values in dependence on whether they are evaluated in terms of a phase-to-ground or a phase-to phase frame of reference,
- performing a first comparison between said first set of predicted current values and sampled values of the current from the same point in time,
- estimating one or more phase-to-phase parameters, such as the phase angle ($\alpha_{xy}$), for the phase-to-phase voltage ($v_{xy}(t)$) between the current paths based on the stored values of the voltage,
- predicting a second set of current values based on said mathematical model of the current, the estimated phase-to-phase parameters, and the stored sampled values of the current,
- performing a second comparison between said second set of predicted current values and sampled values of the current from the same point in time,
- determining whether the first or second set of predicted current values is a valid prediction of the current in the path based on the results of said first and second comparison, and
- if any of the first or second set of predicted current value is found to be valid, predicting future values of the current of the path based on said model and the parameters used for predicting the valid set of current values.

2. The method according to claim 1, wherein said phase-to-ground parameters include the phase shift ($\gamma_x$) of a phase-to-ground voltage ($v_x(t)$) for the current path with respect to a reference phase and said phase-to-phase parameters include the phase shift ($\gamma_{xy}$) of a phase-to-phase voltage ($v_{xy}(t)$) between the current paths with respect to a reference phase.

**3.** The method according to claim 1 or 2, wherein said phase-to-ground parameters include the phase angle ($\alpha_x$) of a phase-to-ground voltage ($v_x(t)$) for the current path and said phase-to-phase parameters include the phase angle ($\alpha_{xy}$) of a phase-to-phase voltage ($v_{xy}(t)$) between the current paths.

**4.** The method according to any of the previous claims, wherein it comprises calculating the deviation between the first and second comparison and based thereon determining whether or not a change in current has occurred in the current path.

**5.** The method according to claim 2, wherein the method comprises: adjusting the estimated phase shift ($\gamma_{xy}$) of the phase-to-phase voltage and the estimated phase shift ($\gamma_x$) of the phase-to-ground voltage upon detecting that a change in the current has occurred in the current path.

**6.** The method according to claim 3, wherein the method comprises: upon detecting that a change in the current has occurred in the current path, determining the point in time when the change in current started, and estimating the phase angle ($\alpha_x$) of the phase-to-ground voltage and the phase angle ($\alpha_{xy}$) of the phase-to-phase voltage at the point in time when the change in current started based on said sampled values of the voltage.

**7.** The method according to any of the previous claims, wherein said sampled values of the current ($i(t)$) for a current path are stored in a moving window, and the method further comprises: upon detecting that a change has occurred in the current in the current path, the moving window for the current is adjusted to discard current values prior to the change in current, and predicting future values of the current based on the present values in the adjusted moving window.

**8.** The method according to any of the previous claims, wherein the method comprises estimating one or more characteristic parameters for the current based on the stored sampled values of the current and the estimated phase-to-ground parameters for the voltage, and predicting future values of the current based on the mathematical model of the current, the estimated phase-to-ground parameters, and the characteristic parameters for the current.

**9.** The method according to any of the previous claims, wherein the method comprises determining whether or not a fault has occurred in the current path based on the deviation between the first and second comparison, and determining which of the phases are involved in the fault based on said first comparisons for all current paths.

**10.** The method according to claim 9, wherein the method comprises determining whether or not there is a three-phase fault, and in case there is a three-phase fault: estimating the time of the current zero for the first phase to interrupt, estimating possible interruption current zeros for the remaining two current paths based on said model and both the phase-to-ground and the phase-to-phase parameters, and selecting for interruption the earliest of the estimated current zeros in each of the remaining paths.

**11.** The method according to any of the previous claims, wherein the method comprises determining whether or not a fault has occurred in the current path based on the deviation between the first and second comparison, and determining whether there is phase-to-phase or a phase-to-ground fault based on said first and second comparisons.

**12.** The method according to any of the previous claims, wherein the method comprises estimating one or more future zero crossings (Z1 - Z5) of the fault current based on the predicted future values of the current, and based on the estimated zero crossings controlling the action of an interruption device arranged in the current path for interrupting the current upon command, in order to optimize the current interruption.

**13.** The method according to any of the previous claims, wherein the method comprises estimating expected interruption current zero times in all phases for an interrupter and in the event of the interrupter failing to interrupt in any or all phases, providing a signal to a back-up protection or back-up interrupter to complete the current interruption process.

**14.** A computer program product directly loadable into the internal memory of a computer, comprising software for performing the steps of any of the claims 1 - 13.

**15.** A computer-readable medium, having a program recorded thereon, where the program is to make a computer perform the steps of any of the claims 1-13, when said program is run on the computer.

**16.** An apparatus for predicting the future behavior of current(s) in current paths (1a-c) forming phases in a multi-phase alternating current electrical power system, the apparatus comprising:

- a first member (3) adapted to continuously sample the voltage (v(t)) for at least one of said current paths and to save the sampled values of the voltage,
- a second member (2) adapted to continuously sample the current (i(t)) for each of the current paths, and to save the sampled values of the currents.

**characterized in that** the apparatus further comprises:

- a computation unit (5) adapted estimate one or more phase-to-ground parameters, such as the phase angle ($\alpha_x$), for the phase-to-ground voltage ($v_x(t)$), and one or more phase-to-phase parameters, such as the phase angle ($\alpha_{xy}$), for the phase-to-phase voltage ($v_{xy}(t)$) between the current paths for each current path based on the stored values of the voltage,
- a predictor arrangement (6) adapted to predict a first set of current values for each current path based on the estimated phase-to-ground parameters, the sampled values of the current, and a mathematical model of the current including one or more characteristic parameters, which parameters have different values in dependence on whether they are evaluated in terms of a phase-to-ground or a phase-to phase frame of reference, and to predict a second set of current values for each current path based on said mathematical model of the current, the estimated phase-to-phase parameters, and the stored sampled values of the current,
- a comparator (8) adapted to perform a first comparison between said first set of predicted current values and sampled values of the current from the same point in time, and to perform a second comparison between said second set of predicted current values and sampled values of the current from the same point in time, and
- an evaluation module (10) adapted to determine whether the first or second set of predicted current values is a valid prediction of the current in the path based on the results of said first and second comparison, and if any of the first or second set of predicted current value is found to be valid, the predictor arrangement is adapted to predict future values of the current of the path based on the parameters used for predicting the valid set of current values.

**17.** The apparatus according to claim 16, wherein said phase-to-ground parameters include the phase shift ($\gamma_x$) of a phase-to-ground voltage ($v_x(t)$) for the current path with respect to a reference phase and said phase-to-phase parameters include the phase shift ($\gamma_{xy}$) of a phase-to-phase voltage ($v_{xy}(t)$) between the current paths with respect to a reference phase.

**18.** The apparatus according to claim 16 or 17, wherein said phase-to-ground parameters include the phase angle ($\alpha_x$) of a phase-to-ground voltage ($v_x(t)$) for the current path and said phase-to-phase parameters include the phase angle ($\alpha_{xy}$) of a phase-to-phase voltage ($v_{xy}(t)$) between the current paths.

**19.** The apparatus according to any of the claims 16 - 18, wherein the apparatus comprises a current change detector (12) adapted to calculate the deviation between the first and second comparison and based thereon determining whether or not a change in the current has occurred in the current path.

**20.** The apparatus according to any of the claims 16 - 19, wherein the computation unit (5) is adapted to upon detecting that a change in current has occurred in the current path, determine the point in time when the change in current started, and to estimate the phase angle ($\alpha_x$) of the phase-to-ground voltage and the phase angle ($\alpha_{xy}$) of the phase-to-phase voltage at the point in time when the change in current started based on said sampled values of the voltage.

**21.** The apparatus according to any of the claims 16 - 20, wherein said second member (2) is adapted to store sampled values of the current (i(t)) in a moving window, and the predictor arrangement unit is adapted to discard current values prior to a change in current, and to predict future values of the current based on current values sampled after the change in current.

**22.** The apparatus according to claim 19, wherein the current change detector (12) is adapted to determining whether or not a fault has occurred in the current path based on the deviation between the first and second comparison, and the evaluation module is adapted to determine which of the phases is involved in the fault based on said first comparisons for all current paths.

**23.** The apparatus according to claim 22, wherein the apparatus comprises a zero crossing estimation unit (14) adapted to estimate possible interruption current zeros for the current paths, and said evaluation module is adapted to determine whether or not there is a three-phase fault, and in case there is a three-phase fault, to estimate the time of the next current zero for the first phase to interrupt, to estimate possible interruption current zeros for the remaining two current paths based on said model and both the phase-to-ground and the phase-to-phase parameters, and to select for interruption the earliest of the estimated current zeros in each of the remaining paths.

**24.** The apparatus according to any of the claims 16 - 23, wherein said current change detector (12) is adapted to determine whether or not a fault has occurred in the current path based on the deviation between the first and second comparison, and the evaluation module is adapted to determine whether there is phase-to-phase or a phase-to-ground fault based on said first and second comparisons.

**25.** The apparatus according to any of the claims 16 - 24, wherein the evaluation module (10) is adapted to determine whether a fault is a 2-phase-to-ground fault or a phase-to-phase without ground fault based on said first and second comparisons.

**26.** Use of the apparatus according to any of the claims 16 - 25 for predicting current zeroes of an asymmetrical fault current in a multi-phase alternating current electrical power system.

**27.** Use the apparatus according to claims 16-25 for predicting expected interruption current zero times in all phases for an interrupter and in the event of the interrupter failing to interrupt in any or all phases, providing a signal to a back-up protection or back-up interrupter to complete the current interruption process.

Fig. 1

EP 1 928 007 A1

Fig. 2

1a  1b  1c

3 — Voltage sampling member

2 — Current sampling member

4 — Protection system processing

18 — Control device → Trip command

5 — Computation unit

U(t)

I(t)

$\gamma_x, \alpha_x$

$\gamma_{xy}, \alpha_{xy}$

6 — Predictor arrangement

$I_P$

$I_{P1}$    $I_{P2}$

8 — Comparator

C1    C2

10 — Evaluation module

12 — Current change detector

14 — Zero crossing estimation unit

16 — Waiting time estimation unit

19 — Circuit Breaker open time Target arcing time

EP 1 928 007 A1

23

$$\gamma_A \quad = \quad 0 \quad \text{rad}$$
$$\gamma_B \quad = \quad -2\pi/3 \; \text{rad}$$
$$\gamma_C \quad = \quad -4\pi/3 \; \text{rad}$$
$$\gamma_{AB} \quad = + \quad \pi/6 \; \text{rad}$$
$$\gamma_{BC} \quad = - \quad \pi/2 \; \text{rad}$$
$$\gamma_{CA} \quad = -7\pi/6 \; \text{rad}$$

Fig. 3

Fig. 4

Fig. 5

Fig. 6

Fig. 7

Fig. 8

Fig. 9a

Fig. 9b

Fig. 10a

Fig. 10b

**European Patent Office**

# EUROPEAN SEARCH REPORT

Application Number

EP 06 12 5262

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 597 999 B1 (SINHA GAUTAM [US] ET AL) 22 July 2003 (2003-07-22) * column 3, line 6 - column 8, line 47; figures 2-6 * | 1,14-16, 26,27 | INV. H01H9/56 H02H3/02 |
| A | PÖLTL A ET AL: "A New Algorithm Enabling Controlled Short Circuit Interruption" IEEE TRANSACTIONS ON POWER DELIVERY, IEEE SERVICE CENTER, NEW YORK, NY, US, vol. 18, no. 3, July 2003 (2003-07), pages 802-808, XP002993857 ISSN: 0885-8977 * the whole document * | 1,14-16, 26,27 | ADD. G01R19/175 G01R19/25 |
| A | WO 01/95354 A (ABB AB [SE]; LARSSON PER [SE]; BACKMAN MAGNUS [SE]; JONSSON LARS [SE]) 13 December 2001 (2001-12-13) * abstract; figure 1 * | 1,14-16, 26,27 | |
| D,A | WO 2006/043871 A (ABB TECHNOLOGY LTD [CH]; THOMAS RICHARD [SE]) 27 April 2006 (2006-04-27) * abstract; figure 2 * | 1,14-16, 26,27 | **TECHNICAL FIELDS SEARCHED (IPC)** H01H H02H G01R |
| D,A | ANTON POELTL ET AL: "TWO NEW METHODS FOR VERY FAST FAULT TYPE DETECTION BY MEANS OF PARAMETER FITTING AND ARTIFICIAL NEURAL NETWORKS" IEEE TRANSACTIONS ON POWER DELIVERY, IEEE SERVICE CENTER, NEW YORK, NY, US, vol. 14, no. 4, October 1999 (1999-10), pages 1269-1275, XP011089163 ISSN: 0885-8977 * the whole document * | 1,14-16, 26,27 | |

The present search report has been drawn up for all claims

| Place of search | Date of completion of the search | Examiner |
|---|---|---|
| Munich | 16 May 2007 | Hijazi, Ali |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 12 5262

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2007

| Patent document cited in search report | | Publication date | Patent family member(s) | | Publication date |
|---|---|---|---|---|---|
| US 6597999 | B1 | 22-07-2003 | NONE | | |
| WO 0195354 | A | 13-12-2001 | AU | 6447701 A | 17-12-2001 |
| | | | CN | 1446366 A | 01-10-2003 |
| | | | EP | 1309978 A1 | 14-05-2003 |
| | | | JP | 2003536211 T | 02-12-2003 |
| | | | SE | 516437 C2 | 15-01-2002 |
| | | | SE | 0002125 A | 08-12-2001 |
| | | | US | 2004090719 A1 | 13-05-2004 |
| WO 2006043871 | A | 27-04-2006 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2006043871 A

- SE 2005001508 W

### Non-patent literature cited in the description

- **ANTON POELTL ; KLAUS FRÖHLICH'S.** Two new methods for very fast fault type detection by means of parameter fitting and artificial neural networks. *IEEE Transactions on Power Delivery,* 1999, vol. 14 (4

- **MONTGOMERY DOUGLAS C ; RUNGER GEORGE C.** Applied Statistics and Probability for Engineers. John Wiley & Sons, Inc, 1999